# EUROPEAN PATENT APPLICATION

(11) **EP 4 838 529 A1**
(43) Date of publication of application: **11.11.2026**
(21) Application number: 26150867.5
(22) Date of filing: 08.01.2026
(51) Int. Cl.: G11C 11/406, G11C 7/24, G11C 11/4078

(54) **SEMICONDUCTOR DEVICE AND OPERATING METHOD OF THE SAME**

(30) Priority: 09.05.2025 KR 20250060587
(71) Applicant: SK hynix Inc., Bubal-eub Icheon-si Gyeonggi-do 17336 (KR)
(72) Inventor: OH, Min Wook, 17336 Icheon-si, Gyeonggi-do (KR); KIM, Ji Eun, 17336 Icheon-si, Gyeonggi-do (KR)
(74) Representative: Isarpatent

(57) **Abstract**

A semiconductor device includes an input control signal generation circuit configured to activate an input control signal by sampling an active signal with a random sampling pulse, an output control signal generation circuit configured to activate an output control signal whenever the number of times that a refresh signal is received reaches a set number of times, and a stop signal generation circuit configured to deactivate a refresh stop signal by the input control signal and configured to activate the refresh stop signal by the output control signal.

## Description

### BACKGROUND

### 1. Technical Field

Embodiments of the present disclosure generally relate to an integrated circuit technology and to a semiconductor device and an operating method of the same.

### 2. Related Art

As the degree of integration of memory is increased, an interval between multiple word lines included in the memory is reduced. As the interval between the multiple word lines is reduced, a coupling effect between adjacent word lines is increased.

A word line toggles between an active state and an inactive state whenever data are input to and output from a memory cell. As the coupling effect between adjacent word lines is increased as described above, corrupted data may be stored in a memory cell connected to a word line adjacent to a frequently activated word line. This phenomenon is called row hammer. Research for overcoming the row hammer continues.

### SUMMARY

In an embodiment of the present disclosure, a semiconductor device may include an input control signal generation circuit configured to activate an input control signal by sampling an active signal with a random sampling pulse, an output control signal generation circuit configured to activate an output control signal whenever the number of times that a refresh signal is received reaches a set number of times, and a stop signal generation circuit configured to deactivate a refresh stop signal by the input control signal and configured to activate the refresh stop signal by the output control signal.

In an embodiment of the present disclosure, a semiconductor device may include an input control signal generation circuit configured to activate a plurality of input control signals by sampling an active signal with a random sampling pulse, an output control signal generation circuit configured to activate a plurality of output control signals whenever the number of times that a refresh signal is received reaches a set number of times, an address latch circuit configured to store a row address whenever the plurality of input control signals is activated and configured to sequentially output one of the stored row addresses as a row hammer target address whenever the plurality of output control signals is activated, and a stop signal generation circuit configured to deactivate a refresh stop signal when one row address is stored in the address latch circuit and configured to activate the refresh stop signal when all of the stored row addresses are output as the row hammer target addresses.

In an embodiment of the present disclosure, an operating method of a semiconductor device may include activating an input control signal by sampling an active signal with a random sampling pulse, storing a row address whenever the input control signal is activated, deactivating a refresh stop signal when the row address is stored, activating an output control signal whenever the number of times that a refresh signal is received reaches a set number of times, outputting one of the stored row addresses as a row hammer target address whenever the output control signal is activated, and confirming that all of the stored row addresses are output as the row hammer target addresses and activating the refresh stop signal.

In an embodiment of the present disclosure, a semiconductor device may include an address latch circuit configured to store a plurality of row hammer target addresses and a stop signal generation circuit configured to activate a refresh stop signal when refresh operations corresponding to all of the plurality of row hammer target addresses stored in the address latch circuit have been completed.

### BRIEF DESCRIPTION OF THE DRAWINGS

FIG. 1 is a diagram for describing a configuration of a semiconductor device according to an embodiment of the present disclosure.
FIG. 2 is a timing diagram for describing an operation of an input control signal generation circuit according to an embodiment of the present disclosure.
FIG. 3 is a timing diagram for describing an operation of an output control signal generation circuit according to an embodiment of the present disclosure.
FIG. 4 is a diagram for describing a configuration of an address latch circuit according to an embodiment of the present disclosure.
FIG. 5 is a diagram for describing a configuration of a stop signal generation circuit according to an embodiment of the present disclosure.
FIG. 6 is a timing diagram for describing an operation of the stop signal generation circuit according to an embodiment of the present disclosure.
FIG. 7 is a diagram for describing a configuration of a semiconductor device according to another embodiment of the present disclosure.
FIG. 8 is a timing diagram for describing an operation of the semiconductor device according to another embodiment of the present disclosure.

### DETAILED DESCRIPTION

Hereinafter, embodiments according to the technical spirit of the present disclosure are described with reference to the accompanying drawings.

Embodiments of the present disclosure relate to a technology for preventing an unnecessary refresh operation, among operations for row hammering handling, and an additional row hammer situation attributable to the unnecessary refresh operation.

It is possible to prevent an additional row hammer situation attributable to the prevention of a malfunction of a refresh operation for row hammering handling and to reduce current consumption attributable to an unnecessary refresh operation.

A semiconductor device according to an embodiment of the present disclosure may be configured to identify a word line that is frequently activated and to refresh adjacent word lines of the identified word line to handle a data loss attributable to row hammer. In this case, a random sampling method is used to identify the word line that is frequently activated. The random sampling method is a method of randomly selecting and sampling some of the activated word lines. A word line that is frequently activated has a high probability that the word line will be sampled by the random sampling method.

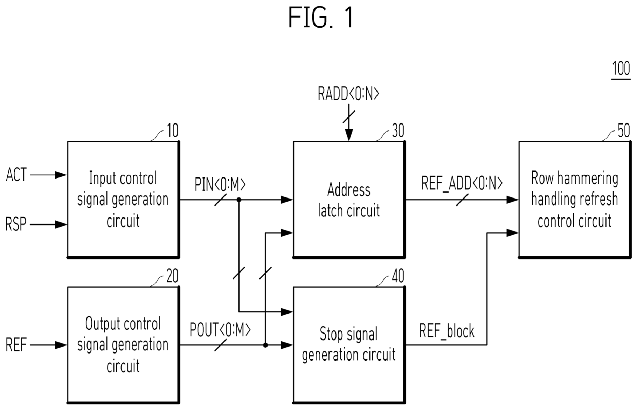

FIG. 1 is a diagram for describing a configuration of a semiconductor device according to an embodiment of the present disclosure.

Referring to FIG. 1, a semiconductor device 100 according to an embodiment of the present disclosure may include an input control signal generation circuit 10, an output control signal generation circuit 20, an address latch circuit 30, a stop signal generation circuit 40, and a row hammering handling refresh control circuit 50.

The input control signal generation circuit 10 may activate input control signals PIN<0:M> , where M is a natural number, based on an active signal ACT and a random sampling pulse RSP. In this case, the random sampling pulse RSP may be a pulse in which timing at which the pulse switches to a specific level and an interval in which the specific level is maintained are randomly changed. That is, the random sampling pulse RSP may be a pulse in which timing at which the pulse is activated and an interval in which the pulse is activated are randomly changed. For example, the input control signal generation circuit 10 may switch the levels of the input control signals PIN<0:M> whenever the activation intervals of the active signal ACT and the random sampling pulse RSP overlap. More specifically, the input control signal generation circuit 10 may activate only the first input control signal PIN<0>, among the input control signals PIN<0:M>, to a specific level for a set time when the activation intervals of the active signal ACT and the random sampling pulse RSP overlap for the first time.

Furthermore, the input control signal generation circuit 10 may activate only the second input control signal PIN<1>, among the input control signals PIN<0:M>, to a specific level for a set time when the activation intervals of the active signal ACT and the random sampling pulse RSP overlap for the second time. The input control signals PIN<0:M> that are generated by the input control signal generation circuit 10 may be provided to the address latch circuit 30 and the stop signal generation circuit 40.

The output control signal generation circuit 20 may activate output control signals POUT<0:M> based on a refresh signal REF. For example, the output control signal generation circuit 20 may switch the levels of the output control signals POUT<0:M> whenever the refresh signal REF is received by a set number of times. More specifically, when the number of times that the refresh signal REF is received reaches a set number of times for the first time, the output control signal generation circuit 20 may activate only the first output control signal POUT<0>, among the output control signals POUT<0:M>, to a specific level for a set time. Furthermore, when the number of times that the refresh signal REF is received reaches the set number of times for the second time, the output control signal generation circuit 20 may activate only the second output control signal POUT< 1>, among the output control signals POUT<0:M>, to a specific level for a set time. The output control signals POUT<0:M> that are generated by the output control signal generation circuit 20 may be provided to the address latch circuit 30 and the stop signal generation circuit 40.

The address latch circuit 30 includes a plurality of latch groups, and may store row addresses RADD<0:N> , where N is a natural number, in one of the plurality of latch groups whenever the levels of the input control signals PIN<0:M> are switched. Furthermore, the address latch circuit 30 may output row addresses stored in one of the plurality of latch groups as row hammer target addresses REF_ADD<0:N> whenever the levels of the output control signals POUT<0:M> are switched. In this case, the row hammer target addresses REF_ADD<0:N> may be provided to the row hammering handling refresh control circuit 50.

The stop signal generation circuit 40 may sequentially switch each level of a plurality of signals one by one to a first level whenever the levels of the input control signals PIN<0:M> are switched, and may sequentially switch each level of the signals one by one from the first level to a second level whenever the levels of the output control signals POUT<0:M> are switched. Furthermore, when all the signals have been switched from the first level to the second level, the stop signal generation circuit 40 may generate a refresh stop signal REF_block that has been activated. The refresh stop signal REF_block may be provided to the row hammering handling refresh control circuit 50.

When receiving the row hammer target addresses REF_ADD<0:N> in the state in which the refresh stop signal REF_block has been deactivated, the row hammering handling refresh control circuit 50 may perform a refresh operation that activates word lines adjacent to a word line corresponding to the row hammer target addresses REF_ADD<0:N>. The row hammering handling refresh control circuit 50 might not perform a refresh operation when the refresh stop signal REF_block is activated.

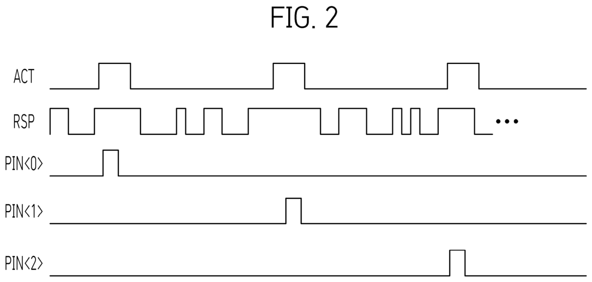

FIG. 2 is a timing diagram for describing an operation of the input control signal generation circuit according to an embodiment of the present disclosure.

The input control signal generation circuit 10 may change the input control signals PIN<0:M> whenever the activation intervals of the active signal ACT and the random sampling pulse RSP overlap. In FIG. 2, an interval in which the active signal ACT is at a high level may be defined as the activation interval of the active signal ACT, and an interval in which the random sampling pulse RSP is at a high level may be defined as the activation interval of the random sampling pulse RSP. However, according to an embodiment, the activation interval of each signal or pulse may be at a low level. In an embodiment of the present disclosure, to define that the interval at the high level is the activation interval is merely an embodiment, and it is to be noted that the embodiments are not limited thereto. Furthermore, in FIG. 2, a case in which the number of input control signals PIN<0:M> is three, that is, M is 2, is described, however, the number of input control signals PIN<0:M> is not limited.

Referring to FIG. 2, the input control signal generation circuit 10 may switch the level of the first input control signal PIN<0>, among the input control signals PIN<0:2>, to a high level for a set time in the first interval in which both the active signal ACT and the random sampling pulse RSP are activated to a high level.

The input control signal generation circuit 10 may switch the level of the second input control signal PIN<1>, among the input control signals PIN<0:2>, to a high level for a set time in the second interval in which both the active signal ACT and the random sampling pulse RSP are activated to a high level.

The input control signal generation circuit 10 may switch the level of the third input control signal PIN<2>, among the input control signals PIN<0:2>, to a high level for a set time in the third interval in which both the active signal ACT and the random sampling pulse RSP are activated to a high level.

As described above, the input control signal generation circuit 10 may sequentially change each of the input control signals PIN<0:M> one by one in each interval in which both the active signal ACT and the random sampling pulse RSP are activated. If an interval in which both the active signal ACT and the random sampling pulse RSP are activated occurs after the last input control signal PIN<M>, among the input control signals PIN<0:M>, switches to a high level for a set time, the input control signal generation circuit 10 may switch the level of the first input control signal PIN<0> to a high level again for a set time.

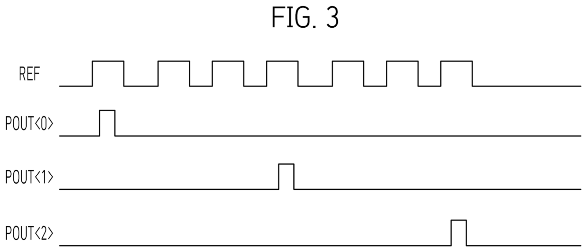

FIG. 3 is a timing diagram for describing an operation of the output control signal generation circuit according to an embodiment of the present disclosure.

The output control signal generation circuit 20 may generate the output control signals POUT<0:M> based on the refresh signal REF. For example, the output control signal generation circuit 20 may switch the levels of the output control signals POUT<0:M> whenever the refresh signal REF is received by a set number of times. In this case, FIG. 3 is a timing diagram for describing an operation of the embodiment in which the set number of times has been defined as three times. It is to be noted that the embodiments of the present disclosure are not limited to the embodiment in which the set number of times is three times. For example, the set number of times may be the number of times which may be changed by a designer or user. Furthermore, in FIG. 3, a case in which the number of output control signals POUT<0:M> is three, that is, M is 2, is described, however, the number of output control signals POUT<0:M> is not limited.

Furthermore, FIG. 3 may illustrate a timing diagram after the output control signal generation circuit 20 confirms that the number of times that the refresh signal REF is received is three and switches the level of the first output control signal POUT<0>, among the output control signals POUT<0:2>, to a high level for a set time.

Referring to FIG. 3, when receiving the refresh signal REF three times after the first output control signal POUT<0> switches to a high level for a set time, the output control signal generation circuit 20 may switch the level of only the second output control signal POUT<1>, among the output control signals POUT<0:2>, to a high level for a set time.

Furthermore, when receiving the refresh signal REF three times after the second output control signal POUT<1> switches to a high level, the output control signal generation circuit 20 may switch only the third output control signal POUT<2>, among the output control signals POUT<0:2>, to a high level for a set time.

As described above, the output control signal generation circuit 20 may sequentially switch each level of the output control signals POUT<0:M> one by one whenever the number of times that the refresh signal REF is received reaches a set number of times. When receiving the refresh signal REF three times after the last output control signal POUT<M> among the output control signals POUT<0:M> switches to a high level for a set time, the output control signal generation circuit 20 may switch the level of the first output control signal POUT<0> to a high level for a set time.

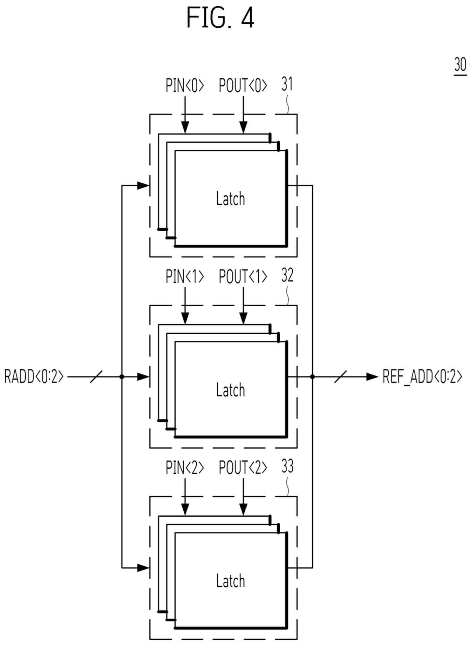

FIG. 4 is a diagram for describing a configuration of the address latch circuit according to an embodiment of the present disclosure.

The address latch circuit 30 includes a plurality of latch groups, and may store the row addresses RADD<0:N> , where N is a natural number, in one of the plurality of latch groups whenever the levels of the input control signals PIN<0:M> are switched. Furthermore, the address latch circuit 30 may output row addresses stored in one of the plurality of latch groups as the row hammer target addresses REF_ADD<0:N> whenever the levels of the output control signals POUT<0:M> are switched. In this case, FIG. 4 may illustrate a configuration of the address latch circuit 30 according to an embodiment in which M and N are each 2. The values of M and N may be changed by a designer or a user.

Referring to FIG. 4, the address latch circuit 30 may include latch groups having a number corresponding to the number of input control signals PIN<0:2> or output control signals POUT<0:2>. Accordingly, the address latch circuit 30 according to an embodiment may include first to third latch groups 31, 32, and 33. Furthermore, each of the first to third latch groups 31, 32, and 33 may include three latches (Latch) that store the three row addresses RADD<0:2>, respectively.

The first latch group 31 may include three latches that store the row addresses RADD<0:2>. The three latches included in the first latch group 31 may store the row addresses RADD<0:2>, respectively, when the first input control signal PIN<0> switches to a high level. For example, when the first input control signal PIN<0> switches to a high level, the first latch may store the first row address RADD<0>. When the first input control signal PIN<0> switches to a high level, the second latch may store the second row address RADD<1>. When the first input control signal PIN<0> switches to a high level, the third latch may store the third row address RADD<2>. When the first output control signal POUT<0> switches to a high level, the three latches included in the first latch group 31 may output the stored row addresses RADD<0:2> as the row hammer target addresses REF _ADD<0:2>, respectively. For example, when the first output control signal POUT<0> switches to a high level, the first latch may output the stored first row address RADD<0> as the first row hammer target address REF_ADD<0>. When the first output control signal POUT<0> switches to a high level, the second latch may output the stored second row address RADD<1> as the second row hammer target address REF _ADD<1>. When the first output control signal POUT<0> switches to a high level, the third latch may output the stored third row address RADD<2> as the third row hammer target address REF _ADD<2>.

The second latch group 32 may include three latches that store the row addresses RADD<0:2>. The three latches included in the second latch group 32 may store the row addresses RADD<0:2>, respectively, when the second input control signal PIN<1> switches to a high level. The three latches included in the second latch group 32 may output the stored row addresses RADD<0:2> as the row hammer target address REF_ADD<0:2> when the second output control signal POUT< 1> switches to a high level.

The third latch group 33 may include three latches that store the row addresses RADD<0:2>, respectively. The three latches included in the third latch group 33 may store the row addresses RADD<0:2>, respectively, when the third input control signal PIN<2> switches to a high level. The three latches included in the third latch group 33 may output the stored row addresses RADD<0:2> as the row hammer target address REF_ADD<0:2> when the third output control signal POUT<2> switches to a high level.

In this case, the first to third latch groups 31, 32, and 33 are different in the names of a signal that controls the storage of each of the row addresses RADD<0:2> and a signal that controls the output of a stored signal and perform the same operation, and thus detailed operations of the second and third latch groups 32 and 33 are substituted with the description of the operation of the first latch group 31.

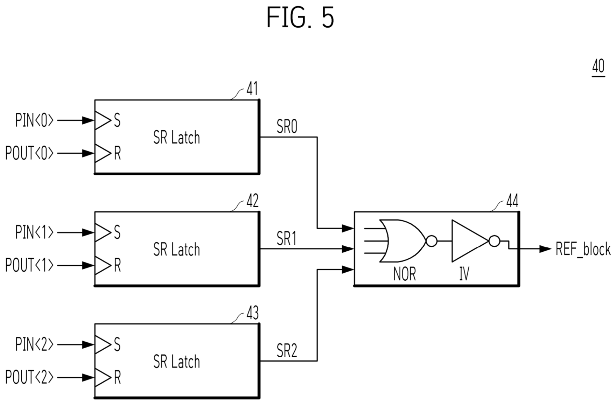

FIG. 5 is a diagram for describing a configuration of the stop signal generation circuit according to an embodiment of the present disclosure

The stop signal generation circuit 40 may sequentially switch each level of a plurality of signals one by one to a first level internally whenever the levels of the input control signals PIN<0:M> are switched, and may sequentially switch each level of the signals one by one from the first level to a second level whenever the levels of the output control signals POUT<0:M> are switched. Furthermore, when all the signals have been switched from the first level to the second level, the stop signal generation circuit 40 may generate the refresh stop signal REF_block that has been activated. The refresh stop signal REF_block may be provided to the row hammering handling refresh control circuit 50. In this case, the plurality of signals the levels of which are switched to the first and second levels by the stop signal generation circuit 40 based on the input control signals PIN<0:M> and the output control signals POUT<0:M> may be latch confirmation signals SR0, SR1, and SR2 illustrated in FIG.5. Furthermore, FIG. 5 merely illustrates a case in which M in the input control signals PIN<0:M> and the output control signals POUT<0:M> is 2 as an embodiment, however, the embodiments of the present disclosure are not limited thereto.

Referring to FIG. 5, the stop signal generation circuit 40 may sequentially switch each level of the latch confirmation signals SR0, SR1, and SR2 one by one to the first level (e.g., a high level) whenever the levels of the input control signals PIN<0:2> are switched, and may switch each level of the signals one by one from the first level to the second level (e.g., a low level) whenever the levels of the output control signals POUT<0:2> are switched. Furthermore, when the latch confirmation signals SR0, SR1, and SR2 having the levels switched to the first level switch to the second level, the stop signal generation circuit 40 may generate the refresh stop signal REF_block that has been activated.

The stop signal generation circuit 40 may include first to third SR latches (SR Latch) 41, 42, and 43 and a signal combination circuit 44. In this case, the number of SR latches included in the stop signal generation circuit 40 may correspond to the number of each of the input control signals PIN<0:M> and the output control signals POUT<0:M>. Accordingly, FIG. 5 illustrates a case in which M is 2, and illustrates that the stop signal generation circuit 40 includes the first to third SR latches 41, 42, and 43 because the number of the input control signals PIN<0:M> is 3 and so is the number of the output control signals POUT<0:M>.

The first SR latch 41 may switch the level of the first latch confirmation signal SR0 to the first level, that is, a high level, when the first input control signal PIN<0> switches to a high level, and may switch the level of the first latch confirmation signal SR0 to the second level, that is, a low level, when the first output control signal POUT<0> switches to a high level.

The second SR latch 42 may switch the level of the second latch confirmation signal SR1 to the first level, that is, a high level when the second input control signal PIN<1> switches to a high level, and may switch the level of the second latch confirmation signal SR1 to the second level, that is, a low level, when the second output control signal POUT<1> switches to a high level.

The third SR latch 43 may switch the level of the third latch confirmation signal SR2 to the first level, that is, a high level, when the third input control signal PIN<2> switches to a high level, and may switch the level of the third latch confirmation signal SR2 to the second level, that is, a low level, when the third output control signal POUT<2> switches to a high level.

When one of the first to third latch confirmation signals SR0, SR1, and SR2 is at a high level, the signal combination circuit 44 may output the refresh stop signal REF_block that has been deactivated to a high level. Furthermore, when all the first to third latch confirmation signals SR0, SR1, and SR2 are at a low level, the signal combination circuit 44 may output the refresh stop signal REF_block that has been activated to a low level.

The signal combination circuit 44 may include a NOR gate NOR and an inverter IV. The NOR gate NOR may receive the first to third latch confirmation signals SR0, SR1, and SR2. The inverter IV may receive the output of the NOR gate NOR and output the refresh stop signal REF_block.

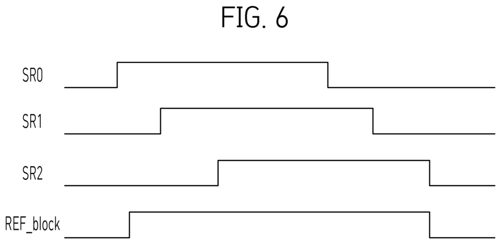

An operation of the stop signal generation circuit 40 of FIG. 5 according to an embodiment is described as follows with reference to FIG. 6.

FIG. 6 is a timing diagram for describing an operation of the stop signal generation circuit according to an embodiment of the present disclosure.

Referring to FIG. 6, when the first input control signal PIN<0> switches to a high level, the first SR latch 41 may switch the level of the first latch confirmation signal SR0 to the first level, that is, a high level. In this case, the signal combination circuit 44 may output the refresh stop signal REF_block that has been deactivated to a high level because the first latch confirmation signal SR0, among the first to third latch confirmation signals SR0, SR1, and SR2, has switched to a high level.

When the second input control signal PIN<1> switches to a high level, the second SR latch 42 may switch the level of the second latch confirmation signal SR1 to the first level, that is, a high level. In this case, the signal combination circuit 44 may maintain the refresh stop signal REF_block that is deactivated to a high level and output because the first and second latch confirmation signals SR0 and SR1, among the first to third latch confirmation signals SR0, SR1, and SR2, are in a high level.

When the third input control signal PIN<2> switches to a high level, the third SR latch 43 may switch the level of the third latch confirmation signal SR2 to the first level, that is, a high level. In this case, the signal combination circuit 44 may maintain the refresh stop signal REF_block that is deactivated to a high level and output because all of the first to third latch confirmation signals SR0, SR1, and SR2 are at a high level.

When the first output control signal POUT<0> switches to a high level, the first SR latch 41 may switch the first latch confirmation signal SR0 to the second level, that is, a low level. In this case, the signal combination circuit 44 may maintain the refresh stop signal REF_block that is deactivated to a high level and output because the second and third latch confirmation signals SR1 and SR2, among the first to third latch confirmation signals SR0, SR1, and SR2, are at a high level.

When the second output control signal POUT<1> switches to a high level, the second SR latch 42 may switch the level of the second latch confirmation signal SR1 to the second level, that is, a low level. In this case, the signal combination circuit 44 may maintain the refresh stop signal REF_block that is deactivated to a high level and output because the third latch confirmation signal SR2, among the first to third latch confirmation signals SR0, SR1, and SR2, is at a high level.

When the third output control signal POUT<2> switches to a high level, the third SR latch 43 may switch the level of the third latch confirmation signal SR2 to the second level, that is, a low level. In this case, the signal combination circuit 44 may output the refresh stop signal REF_block that has been activated to a low level because all the first to third latch confirmation signals SR0, SR1, and SR2 are at a low level.

The semiconductor device 100 constructed as described above according to an embodiment of the present disclosure may sample the active signal ACT from the random sampling pulse RSP. In this case, the active signal ACT sampled from the random sampling pulse RSP may correspond to the input control signals PIN<0:M>. The semiconductor device 100 may store the row addresses RADD<0:N> that are received along with the sampled active signal ACT. The semiconductor device 100 may deactivate the refresh stop signal REF_block to a high level because the semiconductor device 100 is in the state in which the row addresses RADD<0:N> have been stored. In this case, the latch confirmation signal may be a high level. When the number of times that the refresh signal REF is received reaches a set number of times, the semiconductor device 100 may generate the stored row address RADD<0:N> as the row hammer target addresses REF_ADD<0:N>. When the row hammer target addresses REF_ADD<0:N> are generated in the state in which the refresh stop signal REF_block has been deactivated, the semiconductor device 100 may activate word lines adjacent to a word line corresponding to the row hammer target addresses REF_ADD<0:N>. That is, memory cells that are connected to the adjacent word lines may be refreshed. When the row addresses RADD<0:N> are generated as the row hammer target addresses REF_ADD<0:N>, the semiconductor device 100 may switch the level of the latch confirmation signal to a low level. That is, after a row hammering handling refresh operation is performed on the row addresses RADD<0:N> received along with the sampled active signal ACT, the latch confirmation signal may switch to a low level and the refresh stop signal REF_block may be activated to a low level. When the refresh stop signal REF_block is activated, the semiconductor device 100 might not perform a row hammering handling refresh operation.

If the semiconductor device 100 includes a plurality of latch groups that store the row addresses RADD<0:N> received along with the sampled active signal ACT, the latch groups of the semiconductor device 100 may store the row addresses RADD<0:N> whenever the active signal ACT is sampled, and may sequentially switch each level of the plurality of latch confirmation signals to the first level (e.g., a high level) whenever the row addresses RADD<0:N> is stored. Each of the plurality of latch confirmation signals may be sequentially switched one by one from the first level to the second level (e.g., a low level) whenever the stored row addresses RADD<0:N> are used in a row hammering handling refresh operation as the row hammer target addresses REF_ADD<0:N>. When all the row addresses RADD<0:N> stored in the plurality of latch groups have been used in the row hammering handling refresh operation, the plurality of latch confirmation signals may be in the second level. When all of the plurality of latch confirmation signals are in the second level, the refresh stop signal REF_block may be activated. In the state in which the refresh stop signal REF_block has been activated, that is, after the row hammering handling refresh operation is performed on the stored row addresses RADD<0:N> by the sampled active signal ACT, although the number of times that the refresh signal REF is received reaches a set number of times, the semiconductor device 100 might not perform a row hammering handling refresh operation.

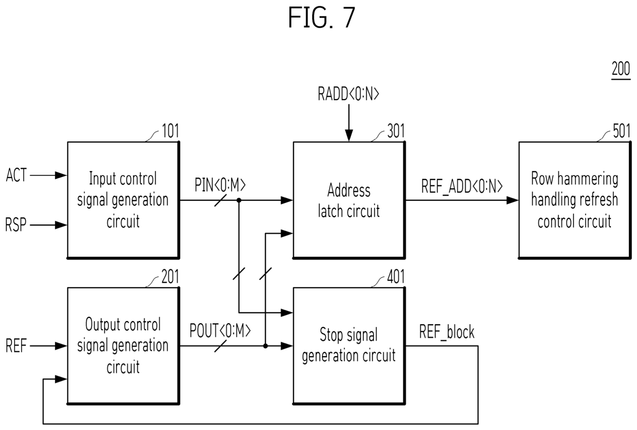

FIG. 7 is a diagram for describing a configuration of a semiconductor device according to another embodiment of the present disclosure.

Referring to FIG. 7, a semiconductor device 200 according to another embodiment of the present disclosure may include an input control signal generation circuit 101, an output control signal generation circuit 201, an address latch circuit 301, a stop signal generation circuit 401, and a row hammering handling refresh control circuit 501.

The input control signal generation circuit 101 may generate input control signals PIN<0:M>, where M is a natural number, based on an active signal ACT and a random sampling pulse RSP. In this case, the random sampling pulse RSP may be a pulse in which timing at which the pulse switches to a specific level and an interval in which the specific level is maintained are randomly changed. That is, the random sampling pulse RSP may be a pulse in which timing at which the pulse is activated and an interval in which the pulse is activated are randomly changed. For example, the input control signal generation circuit 101 may switch the levels of the input control signals PIN<0:M> whenever the activation intervals of the active signal ACT and the random sampling pulse RSP overlap. More specifically, the input control signal generation circuit 101 may switch the level of only the first input control signal PIN<0> among the input control signals PIN<0:M> to a specific level for a set time when the activation intervals of the active signal ACT and the random sampling pulse RSP overlap for the first time. Furthermore, the input control signal generation circuit 101 may switch the level of only the second input control signal PIN<1>, among the input control signals PIN<0:M>, to a specific level for a set time when the activation intervals of the active signal ACT and the random sampling pulse RSP overlap for the second time. The input control signals PIN<0:M> that are generated by the input control signal generation circuit 101 may be provided to the address latch circuit 301 and the stop signal generation circuit 401.

The output control signal generation circuit 201 may generate output control signals POUT<0:M> based on a refresh stop signal REF_block and a refresh signal REF. For example, the output control signal generation circuit 201 may switch the levels of the output control signals POUT<0:M> whenever the refresh signal REF is received by a set number of times in the state in which the refresh stop signal REF_block has been deactivated. More specifically, when the number of times that the refresh signal REF is received reaches a set number of times for the first time in the state in which the refresh stop signal REF_block has been deactivated, the output control signal generation circuit 201 may switch the level of only the first output control signal POUT<0>, among the output control signals POUT<0:M>, to a specific level for a set time. Furthermore, when the number of times that the refresh signal REF is received reaches the set number of times for the second time in the state in which the refresh stop signal REF_block has been deactivated, the output control signal generation circuit 201 may switch the level of only the second output control signal POUT<1> among the output control signals POUT<0:M> to a specific level for the set time. The output control signals POUT<0:M> that are generated from the output control signal generation circuit 201 may be provided to the address latch circuit 301 and the stop signal generation circuit 401.

When the refresh stop signal REF_block is activated, the output control signal generation circuit 201 may prevent the switching of the levels of the output control signals POUT<0:M> regardless of the number of times that the refresh signal REF is received.

The address latch circuit 301 includes a plurality of latch groups, and may store row addresses RADD<0:N> , where N is a natural number, in one of the plurality of latch groups whenever the levels of the input control signals PIN<0:M> are switched. Furthermore, the address latch circuit 301 may output row addresses stored in one of the plurality of latch groups as row hammer target addresses REF_ADD<0:N> whenever the levels of the output control signals POUT<0:M> are switched. In this case, the row hammer target addresses REF _ADD<0:N> may be provided to the row hammering handling refresh control circuit 501.

The stop signal generation circuit 401 may sequentially switch each level of a plurality of signals one by one to a first level internally whenever the levels of the input control signals PIN<0:M> are switched, and may sequentially switch each level of the signals one by one from the first level to a second level whenever the levels of the output control signals POUT<0:M> are switched. Furthermore, when all the signals have been switched from the first level to the second level, the stop signal generation circuit 401 may generate the refresh stop signal REF_block that has been activated. The semiconductor device 200 according to another embodiment of the present disclosure may provide the refresh stop signal REF_block to the output control signal generation circuit 201.

When receiving the row hammer target addresses REF_ADD<0:N>, the row hammering handling refresh control circuit 501 may perform a refresh operation that activates word lines adjacent to a word line corresponding to the row hammer target addresses REF _ADD<0:N>.

The components of the semiconductor device 200 except the output control signal generation circuit 201 illustrated in FIG. 7 may be constructed identically with the components of the semiconductor device 100 illustrated in FIG. 1.

If all of the row addresses RADD<0:N> stored in the address latch circuit 301 have been used in a row hammering handling refresh operation, that is, when the refresh stop signal REF_block is activated, the semiconductor device 200 illustrated in FIG. 7 may stop the switching of the levels of the output control signals POUT<0:M> regardless of the number of times that the refresh signal REF is received. When the switching of the levels of the output control signals POUT<0:M> is stopped, the address latch circuit 301 is prevented from outputting the stored row addresses RADD<0:N> as the row hammer target addresses REF_ADD<0:N>. Accordingly, the row hammering handling refresh control circuit 501 might not perform a row hammer refresh operation.

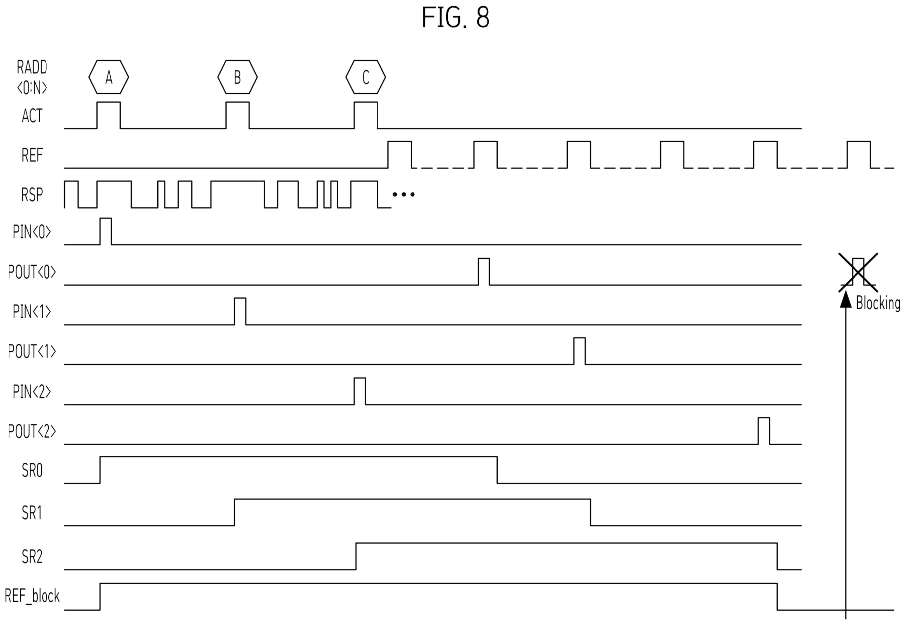

FIG. 8 is a timing diagram for describing an operation of the semiconductor device according to another embodiment of the present disclosure.

The first input control signal PIN<0>, the second input control signal PIN<1>, and the third input control signal PIN<2> may be sequentially switched one by one to a high level for a set time every interval in which both the active signal ACT and the random sampling pulse RSP are activated to a high level. In this case, when the first input control signal PIN<0> switches to a high level, the row addresses RADD<0:N> having a value A may be stored and the first latch confirmation signal SR0 may switch to a high level. When the second input control signal PIN<1> switches to a high level, the row addresses RADD<0:N> having a value B may be stored and the second latch confirmation signal SR1 may switch to a high level. When the third input control signal PIN<2> switches to a high level, the row addresses RADD<0:N> having a value C may be stored and the third latch confirmation signal SR2 may switch to a high level. The refresh stop signal REF_block may switch to a high level while the first latch confirmation signal SR0 switches to a high level.

Thereafter, the refresh signal REF may be received a set number of times. FIG. 8 may illustrate only the refresh signal REF that is received for the first time and the refresh signal REF when the number of times that the refresh signal REF is received reaches a set number of times from the refresh signal REF that is received for the first time.

When the number of times that the refresh signal REF is received reaches the set number of times for the first time, the first output control signal POUT<0> may switch to a high level for a set time. At this time, a row hammering handling refresh operation may be performed because the row addresses RADD<0:N> having the stored value A are output as the row hammer target addresses REF_ADD<0:N>, and the first latch confirmation signal SR0 that maintains a high level may switch to a low level.

When the number of times that the refresh signal REF is received reaches the set number of times for the second time, the second output control signal POUT< 1> may switch to a high level for a set time. At this time, a row hammering handling refresh operation may be performed because the row addresses RADD<0:N> having the stored value B are output as the row hammer target addresses REF_ADD<0:N>, and the second latch confirmation signal SR1 that maintains a high level may switch to a low level.

When the number of times that the refresh signal REF is received reaches the set number of times for the third time, the third output control signal POUT<2> may switch to a high level for a set time. At this time, a row hammering handling refresh operation may be performed because the row addresses RADD<0:N> having the stored value C are output as the row hammer target addresses REF_ADD<0:N>, and the third latch confirmation signal SR2 that maintains a high level may switch to a low level.

When all the first to third latch confirmation signals SR0, SR1, and SR2 have been switched to a low level, the refresh stop signal REF_block may be switched from a high level to a low level.

When the refresh stop signal REF_block is activated to a low level, although the number of times that the refresh signal REF is received reaches a set number of times, the subsequent generation of the first output control signal POUT<0> can be prevented. In this case, after the first output control signal POUT<0>, the second output control signal POUT<1>, and the third output control signal POUT<2> are switched to a high level for a set time whenever the number of times that the refresh signal REF is received reaches the set number of times, each level of the first output control signal POUT<0>, the second output control signal POUT<1>, and the third output control signal POUT<2> may be sequentially switched one by one again.

As a result, the semiconductor device 200 according to another embodiment of the present disclosure can prevent an unnecessary row hammering handling refresh operation from being performed by preventing the generation of the output control signal although the number of times that the refresh signal REF is received reaches a set number of times when all of row hammering handling refresh operations are performed on the row addresses RADD<0:N> having the stored values A, B, and C.

Although embodiments according to the technical scope of the present disclosure have been described above with reference to the accompanying drawings, the embodiments have been provided to describe the technical scope to one of ordinary skill in the art. However, the embodiments of the present disclosure are not limited to the described embodiments. A person having ordinary knowledge in the art may substitute, modify, and change the embodiments in various ways without departing from the technical scope of the present disclosure written in the claims. Such substitutions, modifications, and changes to the embodiments may be said to belong to the technical scope of the present disclosure. Furthermore, the embodiments may be combined to form additional embodiments.

## Claims

**1.** A semiconductor device comprising:
an address latch circuit configured to store a plurality of row hammer target addresses; and
a stop signal generation circuit configured to activate a refresh stop signal when refresh operations corresponding to all the plurality of row hammer target addresses stored in the address latch circuit have been completed.

**2.** The semiconductor device of claim 1, further comprising a row hammering handling refresh control circuit configured to perform a refresh operation that activates word lines adjacent to a word line corresponding to the row hammer target address when the refresh stop signal is deactivated and configured to stop the refresh operation when the refresh stop signal is activated.3. The semiconductor device of claim 1, further comprising;
an input control signal generation circuit configured to activate a plurality of input control signals by sampling an active signal with a random sampling pulse, and
an output control signal generation circuit configured to activate a plurality of output control signals in response to a refresh signal received a set number of times,
wherein the address latch circuit configured to store a row address whenever any of the plurality of input control signals is activated and configured to sequentially output each of the stored row addresses as the row hammer target address whenever any of the plurality of output control signals is activated; and
the stop signal generation circuit configured to deactivate the refresh stop signal when at least one row address is stored in the address latch circuit and configured to activate the refresh stop signal when all the stored row addresses have been output as the row hammer target addresses.

**4.** The semiconductor device of claim 3, wherein:
the plurality of input control signals comprises a first input control signal and a second input control signal,
the plurality of output control signals comprises a first output control signal and a second output control signal, and
the stop signal generation circuit comprises:
a first SR latch configured to switch a level of a first latch confirmation signal to a first level when the first input control signal is activated and configured to switch the level of the first latch confirmation signal to a second level when the first output control signal is activated,
a second SR latch configured to switch a level of a second latch confirmation signal to the first level when the second input control signal is activated and configured to switch the level of the second latch confirmation signal to the second level when the second output control signal is activated; and
a signal combination circuit configured to deactivate the refresh stop signal when the level of at least one of the first and second latch confirmation signals is the first level and configured to activate the refresh stop signal when the levels of both the first and second latch confirmation signals are the second level.

**5.** The semiconductor device of claim 4, wherein the address latch circuit comprises:
a first latch group configured to store the row address when the first input control signal is activated and configured to output the stored row address as a row hammer target address when the first output control signal is activated, and
a second latch group configured to store the row address when the second input control signal is activated and configured to output the stored row address as the row hammer target address when the second output control signal is activated.

**6.** The semiconductor device of claim 3, wherein the output control signal generation circuit
generates the plurality of output control signals based on the number of times that the refresh signal is received only in a state in which the refresh stop signal has been deactivated, and
prevents the generation of the plurality of output control signals regardless of the number of times that the refresh signal is received in a state in which the refresh stop signal has been activated.

**7.** An operating method of a semiconductor device, the operating method comprising:
activating an input control signal by sampling an active signal with a random sampling pulse;
storing a row address whenever the input control signal is activated;
deactivating a refresh stop signal upon storing the row address;
activating an output control signal in response to a refresh signal received a set number of times;
outputting one of the stored row addresses as a row hammer target address whenever the output control signal is activated; and
activating the refresh stop signal when all the stored row addresses have been output as the row hammer target addresses.

**8.** The operating method of claim 7, further comprising:
confirming that the refresh stop signal has been deactivated and performing a refresh operation that activates word lines adjacent to a word line corresponding to the row hammer target address, and
confirming that the refresh stop signal is activated and stopping the refresh operation.

**9.** The operating method of claim 7, wherein activating the output control signal comprises:
confirming that the refresh stop signal has been deactivated and activating the output control signal whenever the number of times that the refresh signal is received reaches the set number of times, and
confirming that the refresh stop signal is activated and preventing the activation of the output control signal regardless of the number of times that the refresh signal is received.

**10.** The operating method of claim 7, wherein deactivating the refresh stop signal comprises:
sequentially switching each level of a plurality of latch confirmation signals one by one to a first level whenever the input control signal is activated; and
deactivating the refresh stop signal when a level of at least one of the plurality of latch confirmation signals is the first level.

**11.** The operating method of claim 10, wherein activating the refresh stop signal comprises:
sequentially switching each level of the plurality of latch confirmation signals one by one to a second level whenever the output control signal is activated; and
activating the refresh stop signal when the levels of all the plurality of latch confirmation signals are the second level.
